(19) Europäisches Patentamt
European Patent Office
Office européen des brevets

(11) EP 3 143 692 B1

(12) **FASCICULE DE BREVET EUROPEEN**

(45) Date de publication et mention
de la délivrance du brevet:
**15.04.2020 Bulletin 2020/16**

(21) Numéro de dépôt: **15721747.2**

(22) Date de dépôt: **13.05.2015**

(51) Int Cl.:
***H03D 7/00*** *(2006.01)*

(86) Numéro de dépôt international:
**PCT/EP2015/060695**

(87) Numéro de publication internationale:
**WO 2015/173356 (19.11.2015 Gazette 2015/46)**

(54) **CIRCUIT MÉLANGEUR À CONTENU HARMONIQUE COMPENSABLE**

MISCHERSCHALTUNG MIT KOMPENSIERBAREM OBERSCHWINGUNGSGEHALT

MIXER CIRCUIT WITH COMPENSABLE HARMONIC CONTENT

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **13.05.2014 FR 1401079**

(43) Date de publication de la demande:
**22.03.2017 Bulletin 2017/12**

(73) Titulaire: **THALES**
**92400 Courbevoie (FR)**

(72) Inventeurs:
• **CRETE, Denis**
**91767 Palaiseau (FR)**
• **MARCILHAC, Bruno**
**91767 Palaiseau (FR)**

• **LEMAITRE, Yves, Eric, Jacques**
**91767 Palaiseau (FR)**

(74) Mandataire: **Lavoix**
**2, place d'Estienne d'Orves**
**75441 Paris Cedex 09 (FR)**

(56) Documents cités:
**EP-A2- 0 524 473    US-A- 4 051 393
US-A- 5 646 526    US-A1- 2007 077 906
US-B1- 8 179 133**

• **KORNEV V K ET AL: "Dc SQUID array with
nonlinear inductance", JOURNAL OF PHYSICS:
CONFERENCE SERIES, INSTITUTE OF PHYSICS
PUBLISHING, BRISTOL, GB, vol. 234, no. 4, 22
juillet 2010 (2010-07-22), page 42034,
XP020193675, ISSN: 1742-6596, DOI:
10.1088/1742-6596/234/4/042034**

EP 3 143 692 B1

**Description**

La présente invention concerne un mélangeur.

Dans le domaine du traitement du signal radiofréquence, il est souhaitable de traiter le signal sur de larges bandes de fréquences. Lorsque la bande de fréquences est trop importante, il n'existe pas d'amplificateur pouvant fonctionner sur l'intégralité de la bande de fréquences. Il convient alors de découper la bande de fréquences en plusieurs sous-bandes et de transposer chacune des sous-bandes dans une gamme de fréquence plus basse à l'aide d'un mélangeur qui est généralement un composant non-linéaire dont la fonction de transfert F théorique est $F = a.A.B$ où $a$ est un constante de proportionnalité et $A$ et $B$ sont deux signaux représentatifs d'une grandeur électrique (tension, courant ou impédance).

Néanmoins, en pratique, l'utilisation d'un mélangeur conduit à l'apparition de nombreuses raies aux fréquences $n.f_{signal} - m.f_{OL}$ où $n$ et $m$ prennent des valeurs entières avec $f_{signal}$ la fréquence du signal et $f_{OL}$ la fréquence de l'oscillateur local. Ces raies sont non désirées hormis pour les cas $n.m=1$.

Des applications de dispositifs supraconducteurs à interférence quantique sont connus du document US 4 051 393 A, du document US 5 646 526 A, du document EP05024473, du document US 8 179 133 B1 ainsi que de l'article de Kornev et al. intitulé *« DC SQUID array with nonlinear inductance »*.

Il existe donc un besoin pour un mélangeur permettant d'éviter au maximum ces raies parasites.

A cet effet, l'invention propose un mélangeur comprenant une entrée d'injection d'un premier signal, deux entrées pour un deuxième signal, la différence de potentiel entre les deux entrées correspondant à la tension du deuxième signal ou la différence de potentiel entre les deux entrées étant nulle, le deuxième signal étant appliqué sur chacune des deux entrées, deux sorties, la différence de potentiel entre les deux sorties correspondant à une multiplication du premier signal avec le deuxième signal, deux premiers éléments supraconducteurs à interférence quantique montés en différentiel formant un premier doublet, et reliés chacun à une des sorties du mélangeur et à une des deux entrées pour le deuxième signal, et un moyen de contrôle de la différence de flux magnétique appliqué aux deux éléments supraconducteurs à interférence quantique du premier doublet.

Suivant des modes de réalisation particuliers, le mélangeur comprend une ou plusieurs des caractéristiques suivantes, prise(s) isolément ou suivant toutes les combinaisons techniquement possibles :

- sont interposés en série entre les deux premiers éléments supraconducteurs à interférence quantique et les deux sorties : au moins deux deuxièmes doublets comprenant deux éléments supraconducteurs à interférence quantique montés en différentiel et reliés chacun à une des sorties du mélangeur et à une des deux entrées pour le deuxième signal, et un moyen de contrôle de la différence de flux magnétique appliqué aux deux éléments supraconducteurs à interférence quantique de chaque deuxième doublet.
- au moins un élément supraconducteur à interférence quantique est un dispositif supraconducteur à interférence quantique à courant continu ou un réseau d'éléments supraconducteurs à interférence quantique connectés en parallèle.
- l'un au moins des éléments supraconducteurs à interférence quantique des doublets est un composant supraconducteur, comprenant une première boucle supraconductrice, la première boucle supraconductrice comportant une première branche comprenant une première jonction Josephson et une deuxième branche comprenant un premier dispositif supraconducteur à interférence quantique à courant continu.
- le premier dispositif supraconducteur à interférence quantique à courant continu du ou de chaque composant comporte une deuxième jonction Josephson et une troisième jonction Josephson, un courant critique étant défini pour chaque jonction Josephson, le courant critique de la première jonction Josephson est supérieur à la valeur absolue de la différence entre le courant critique de la troisième jonction Josephson et le courant critique de la deuxième jonction Josephson et inférieur à la somme du courant critique de la deuxième jonction Josephson et du courant critique de la troisième jonction Josephson.
- le ou chaque composant comprend des moyens de génération de flux magnétique agencés de façon à injecter efficacement un flux magnétique dans la première boucle supraconductrice et le premier dispositif supraconducteur à interférence quantique à courant continu. Dans un tel cas, les moyens de génération de flux magnétique sont ainsi un moyen de contrôler le courant de boucle de façon à ajuster le courant critique du premier dispositif supraconducteur à interférence quantique à courant continu.
- au moins un composant comprend en outre une quatrième jonction Josephson en parallèle avec une partie de la première branche et une partie de la deuxième branche, les deux parties formant une inductance de boucle en parallèle de la quatrième jonction Josephson.
- la deuxième branche d'au moins un composant comprend le premier dispositif supraconducteur à interférence quantique à courant continu, monté en parallèle avec une inductance de boucle formée par une partie de la première branche et une partie de la deuxième branche, l'ensemble étant monté en série avec une quatrième jonction Josephson dont le courant critique est égal au courant critique de la première jonction Josephson à 1% près. Il est

2

possible de réaliser le composant avec un écart de courant critique plus grand que 1%, mais avec des performances réduites en terme d'amplitude de modulation.

- ledit au moins un composant comprend en outre une cinquième jonction Josephson agencée pour que la première jonction Josephson et la cinquième jonction Josephson forment un deuxième dispositif supraconducteur à interférence quantique à courant continu distinct du premier dispositif supraconducteur à interférence quantique à courant continu.
- ledit au moins un composant comprend en outre une cinquième jonction Josephson agencée pour que la première jonction Josephson et la cinquième jonction Josephson forment un deuxième dispositif supraconducteur à interférence quantique à courant continu distinct du premier dispositif supraconducteur à interférence quantique à courant continu, et une sixième jonction Josephson agencée pour que la quatrième jonction Josephson et la cinquième jonction Josephson forment un troisième dispositif supraconducteur à interférence quantique à courant continu distinct du premier dispositif supraconducteur à interférence quantique à courant continu et du deuxième dispositif supraconducteur à interférence quantique.

D'autres caractéristiques et avantages de l'invention apparaîtront à la lecture de la description détaillée qui suit, de modes de réalisation de l'invention, donnés à titre d'exemple uniquement et en références aux dessins qui sont :

- figure 1, un schéma d'un exemple de mélangeur comprenant des SQUID ;
- figure 2, un schéma d'implémentation d'un composant supraconducteur selon un premier mode de réalisation ;
- figure 3, un schéma électrique équivalent au composant selon le premier mode de réalisation ;
- figure 4, un graphique montrant l'évolution de la phase $\delta$ des jonctions Josephson du composant selon le premier mode de réalisation en fonction du flux magnétique appliqué à la jonction Josephson ajustable ;
- figure 5, un schéma d'implémentation d'un composant supraconducteur « Bi-SQUID » modifié correspondant à un deuxième mode de réalisation ;
- figure 6, un schéma électrique équivalent à un composant « Bi-SQUID » selon l'état de la technique ;
- figure 7, un schéma électrique équivalent au composant « Bi-SQUID » modifié conformément à la figure 5 ;
- figure 8, un schéma d'implémentation d'un composant supraconducteur selon le troisième mode de réalisation ;
- figure 9, un schéma électrique équivalent au composant selon le troisième mode de réalisation ;
- figure 10, un schéma électrique d'implémentation d'un composant supraconducteur selon un quatrième mode de réalisation ;
- figure 11, un schéma électrique équivalent au composant selon le quatrième mode de réalisation ;
- figure 12, un schéma électrique équivalent à un composant supraconducteur selon un cinquième mode de réalisation;
- figure 13, un schéma électrique équivalent à un composant selon un sixième mode de réalisation de l'invention ;
- figure 14, un schéma d'un mélangeur agencé similairement à la figure 1 avec des composants conformes à celui de la figure 2 à la place des SQUID.

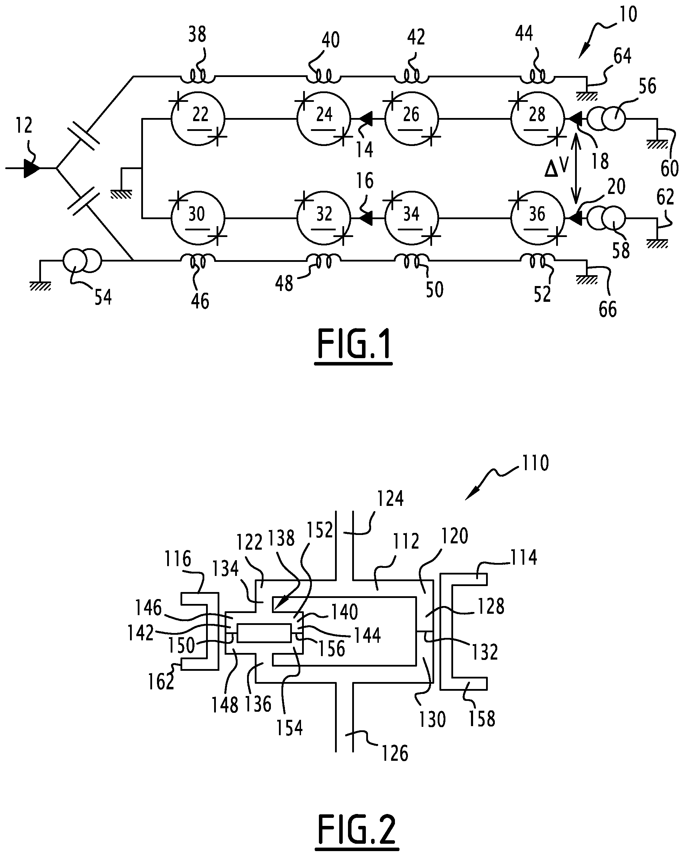

Un mélangeur 10 est représenté à la figure 1. Le mélangeur 10 a pour fonction de générer un signal d'amplitude proportionnel à celle d'un signal radiofréquence $I_{RF}$ et de fréquence $\omega_S - \omega_{OL}$ à partir d'un signal d'entrée $I_S$ à la fréquence $\omega_S$ et d'un signal d'oscillateur local $I_{OL}$ à la fréquence $\omega_{OL}$.

Le mélangeur 10 comporte une entrée 12 pour le signal d'entrée, deux entrées 14 et 16 pour le signal de l'oscillateur local, deux sorties 18, 20, huit dispositifs supraconducteur à interférences quantiques 22, 24, 26, 28, 30, 32, 34 et 36, huit inductances 38, 40, 42, 44, 46, 48, 50 et 52 positionnées chacune en regard d'un des huit dispositifs supraconducteur à interférences quantiques 22, 24, 26, 28, 30, 32, 34 et 36 respectif, une alimentation 54 des inductances et deux générateurs de polarisation 56, 58 des huit dispositifs supraconducteurs à interférences quantiques 22, 24, 26, 28, 30, 32, 34 et 36.

Par souci de simplification, le circuit générant les polarisations en flux opposées, est ici représenté schématiquement, commun avec le circuit de couplage du signal d'entrée, mais ceci n'est qu'une possibilité, d'autres modes de réalisations étant envisageables. Par exemple, si l'onde de l'oscillateur local est appliquée aux entrées 14 et 16 avec la même phase, alors les courants de polarisations en flux sont de préférence égaux dans les inductances 38, 40, 50 et 52, et opposés à ceux qui circulent dans les inductances 42, 44, 46 et 48.

Une autre configuration préférable est d'appliquer l'onde de l'oscillateur local aux entrées 14 et 16 avec un déphasage de $\pi$ radians. La différence de potentiel entre les deux entrées 14 et 16 pour le signal de l'oscillateur local correspond à la tension du signal de l'oscillateur local délivrant un courant $I_{ol}$. Les courants de polarisations en flux sont alors égaux dans les inductances 38, 40, 46 et 48, et opposés à ceux qui circulent dans les inductances 42, 44, 50 et 52.

Dans les deux cas, les polarisations en flux magnétique sont aisément implémentées par l'utilisation d'au plus quatre générateurs de courant (un seul, référencé 54 étant représenté sur la figure 1) connectés tel que représenté figure 1 pour le générateur de courant 54, entre les inductances 48 et 50 pour le second, et symétriquement, entre les inductances 40 et 42 pour le troisième et à l'inductance 38 pour le quatrième.

La composante fondamentale de la différence de potentiel ΔV entre les deux sorties 18 et 20 correspond à une multiplication du signal d'entrée $I_s$ avec le signal de l'oscillateur local $I_{ol}$.

Un dispositif supraconducteur à interférences quantiques 22, 24, 26, 28, 30, 32, 34 et 36 est noté SQUID (qui renvoie à « superconducting quantum interference device ») dans toute la suite de la description. Un tel dispositif est utilisé dans de multiples applications dont la détermination des susceptibilités magnétiques de minuscules échantillons sur une large plage de température, la détection de la résonance nucléaire magnétique et quadripolaire, en métrologie (standard du volt, mesure de la température à l'aide de mesures de bruit également appelée thermométrie de bruit), le biomagnétisme, la géophysique, le magnétisme des roches ou le paléomagnétisme.

Pour cela, il est fait usage de l'effet Josephson. Par définition, l'effet Josephson se manifeste par l'apparition d'un courant, également appelé supracourant, entre deux matériaux supraconducteurs séparés par une couche non supraconductrice, e.g. formée d'un matériau isolant ou métallique non supraconducteur. L'ensemble des deux matériaux supraconducteurs et de la couche est appelé une « jonction Josephson ».

L'apparition de ce courant s'explique par la théorie macroscopique de la supraconductivité développée par John Bardeen, Leon Cooper et Robert Schrieffer. Selon cette théorie, en-dessous de la température de transition supraconductrice, au moins une partie des électrons libres dans le matériau supraconducteur sont liés entre eux, de manière à former des paires d'électrons dites « paires de Cooper ».

La supraconductivité est un phénomène quantique macroscopique induisant un ordre à l'échelle macroscopique, ce qui a trois conséquences principales : une conductivité électrique infinie d'un anneau supraconducteur justifiant l'existence d'un courant permanent de paires de Cooper, la quantification du flux magnétique à travers un anneau supraconducteur résultant de l'application d'un champ magnétique et du courant induit dans l'anneau et l'effet Josephson aussi appelé effet tunnel Josephson. Pour expliquer ce dernier phénomène, considérons deux supraconducteurs séparés par une mince barrière isolante à travers laquelle les paires de Cooper peuvent passer par un effet tunnel quantique, en maintenant la cohérence de phase entre les deux supraconducteurs durant le processus. Josephson a montré que la différence δ entre les phases des fonctions d'onde des deux côtés de la jonction Josephson est en relation avec le supracourant $I$ circulant à travers la barrière et la tension $V$ aux bornes de la jonction Josephson, par les relations suivantes :

$$\begin{cases} \sin\delta = \dfrac{I}{I_C} \\[2ex] V = \dfrac{\Phi_0}{2\pi}\dfrac{\partial\delta}{\partial t} \end{cases}$$

Où:

- $I_C$ est le courant critique, qui est le supracourant continu maximal que peut supporter la jonction Josephson. Ce courant critique est lié à la transparence de la barrière et à la densité de paires de Cooper dans les électrodes.
- $\Phi_O$ est le quantum de flux, qui est le rapport entre la constante de Planck et la charge d'une paire de Cooper.

Dans une jonction Josephson, le courant de paires de Cooper contribue au transport électronique, mais en parallèle, il existe classiquement le courant d'électrons célibataires (« quasiparticules ») associé à un terme dissipatif caractérisé par une résistance $R_n$. Il en résulte une équation différentielle de premier ordre en δ, qui peut se résoudre analytiquement pour donner l'évolution temporelle de δ, ce qui donne après une moyenne temporelle l'équation suivante:

$$\langle V \rangle = \frac{\Phi_0}{2\pi}\left\langle \frac{\partial\delta}{\partial t}\right\rangle = V_C \sqrt{\left(\frac{I}{I_C}\right)^2 - 1}$$

Où $V_C = R_n.I_C$ est la tension caractéristique de la jonction Josephson.

Plus spécifiquement, un SQUID est une boucle supraconductrice (piste fermée formée d'au moins un matériau supraconducteur, électriquement équivalente à une inductance de valeur $L$) interrompue par au moins une couche isolante, chaque interruption formant une jonction Josephson. Les grandeurs d'inductance $L$ de la boucle supraconductrice et du ou des courants critiques $Ic$ des jonctions Josephson sont liées par le rapport $RI$ entre le produit $L.Ic$ et le quantum de flux $\Phi_0$. Ce rapport $R1$ est de préférence compris entre 0,2 et 4. Cela se traduit mathématiquement par les relations suivantes :

$$RI = \frac{L I_C}{\Phi_0} \quad \text{et} \quad 0{,}2 \leq RI \leq 4$$

Les SQUID 22, 24, 26, 28, 30, 32, 34 et 36, sont agencés selon deux lignes 60, 62 qui sont reliées respectivement aux deux générateurs de polarisation 56 et 58 ainsi qu'aux deux entrées 14 et 16. Les premier, deuxième, troisième et quatrième SQUID 22, 24, 26, 28 de la gauche vers la droite sur la figure 1, sont agencés en série le long de la première ligne 60. Les cinquième, sixième, septième et huitième SQUID, 30, 32, 34, 36 de la gauche vers la droite sur la figure 1, sont agencés en série le long de la deuxième ligne 32. La première entrée 14 pour le signal de l'oscillateur local se trouve entre le deuxième SQUID 24 et le troisième SQUID 26. La deuxième entrée 16 pour le signal de l'oscillateur local se trouve entre le sixième SQUID 32 et le septième SQUID 34.

Chaque SQUID 22, 24, 26, 28, 30, 32, 34 et 36 est monté selon une paire en différentiel également appelée « doublet », c'est-à-dire que chaque SQUID 22, 24, 26, 28 de la première ligne 60 est en regard d'un SQUID 30, 32, 34 et 36 respectif de la deuxième ligne 62. Plus précisément, le premier SQUID 22 est en regard du cinquième SQUID 30, le deuxième SQUID 24 est en regard du sixième SQUID 32, le troisième SQUID 26 est en regard du septième SQUID 34 et le quatrième SQUID 28 est en regard du huitième SQUID 36.

De même que les SQUID 22, 24, 26, 28, 30, 32, 34 et 36, les huit inductances 38, 40, 42, 44, 46, 48, 50 et 52 sont agencées en série selon deux lignes, une troisième ligne 64 et une quatrième ligne 66. Les troisième et quatrième lignes 64, 66 sont reliées à l'entrée 12. La quatrième ligne 66 est reliée à l'alimentation 54 des inductances.

Les première, deuxième, troisième et quatrième inductances 38, 40, 42 et 44, de la gauche vers la droite sur la figure 1, sont agencées en série le long de la troisième ligne 64. Les cinquième, sixième, septième et huitième inductances 46, 48, 50 et 52, de la gauche vers la droite sur la figure 1, sont agencées en série le long de la quatrième ligne 66.

L'alimentation des inductances 54 est propre à faire générer aux inductances de la troisième ligne 64 un flux de polarité opposée à celui généré par les inductances de la quatrième ligne 66.

Chacun des générateurs de polarisation 56, 58 est propre à polariser chacun des huit SQUID 22, 24, 26, 28, 30, 32, 34 et 36 avec un courant de polarisation noté $I_{DC}$.

Il est à noter que l'illustration de la figure 1 montre huit SQUID (quatre « doublets »), mais bien entendu, le mélangeur 10 pourrait comporter un nombre de doublets quelconque, préférablement pair. De même pour les inductances schématisant un couplage magnétique entre le circuit d'entrée du signal et chacun des « doublets ». Dans chaque doublet, les deux SQUID peuvent être simultanément remplacés par des réseaux de SQUID en parallèle.

Le fonctionnement du mélangeur 10 est maintenant décrit.

Il est possible de considérer qu'il comprend deux amplificateurs dont le gain est modulé électriquement. Par commodité pour la suite, il est défini une fonction de transfert $Z_{21}$ telle que :

$$\Delta V = Z_{21}(I_{OL}).I_S$$

Où $I_s$ est le signal à amplifier ; et $I_{OL}$ l'onde de l'oscillateur local.

Dans le mode de réalisation préféré, introduire un signal d'oscillateur local sur les entrées 14 et 16 revient à introduire un signal de polarisation $I_0^+ = I_{DC} + \dfrac{I_{OL}}{2}$ pour les SQUID 22, 24, placés sur la première ligne 60, 30 et 32 placés dans la deuxième ligne 62 et un signal de polarisation $I_0^- = I_{DC} - \dfrac{I_{OL}}{2}$ pour les SQUID 26, 28 placés sur la première ligne 60, 34 et 36 placés dans la deuxième ligne 62.

De ce fait, la réponse du mélangeur 10 à un tel signal est :

$$\Delta(\Delta V) = \Delta V(I_0^+) - \Delta V(I_0^-) = I_S.\left(Z_{21}(I_0^+) - Z_{21}(I_0^-)\right)$$

Un développement limité au troisième ordre en $I_{OL}$ permet d'obtenir l'expression suivante :

$$\Delta(\Delta V) = \frac{I_S}{2} \cdot \left[ I_{OL} \cdot \left( \frac{\partial Z_{21}}{\partial I_0} \right)_{I_0=I_{DC}} + \frac{I_{OL}^3}{4} \cdot \left( \frac{\partial^3 Z_{21}}{\partial I_0^3} \right)_{I_0=I_{DC}} \right]$$

Le premier terme de l'expression précédente correspond à la fonction du mélangeur 10. Le deuxième terme de l'expression précédente est un terme parasite correspondant à la présence d'un signal à la fréquence $3\omega_{OL} - \omega_S$ et d'un signal à la fréquence $3\omega_{OL} + \omega_S$.

Ainsi, le mélangeur 10 permet d'obtenir en sortie un signal pour lequel sur toute la bande de fréquence comprise entre 0 et $3\omega_{OL}$, le seul signal parasite est un signal ayant une fréquence à $3\omega_{OL} - \omega_S$.

Le mélangeur 10 supraconducteur a intrinsèquement un bruit très faible et une très grande bande passante. La puissance de l'oscillateur local varie en rapport avec la dynamique, selon le nombre de SQUID utilisés. L'impédance du circuit vue de l'oscillateur local dépend de la configuration choisie pour appliquer le signal d'oscillateur local aux entrées 14 et 16, le mode de réalisation préféré présentant une impédance quatre fois supérieure, il sera plus facile de coupler la puissance délivrée par le générateur.

L'utilisation d'un composant supraconducteur 110 tel que proposé à la figure 2 permet de réduire encore plus le nombre de raies satellites générées par les non-linéarités du mélangeur 10. Avant de décrire un exemple de mélangeur 10 utilisant un tel composant, le composant supraconducteur 110 est d'abord décrit.

Le composant 110 comporte une première boucle 112 supraconductrice, un premier moyen de couplage 114 à un flux magnétique externe, un deuxième moyen de couplage 116 à un flux magnétique externe, une première branche 120, une deuxième branche 122, des accès électriques 124 et 126 sous forme d'une entrée 124 et une sortie 126, les deux branches 120, 122 étant chacune reliées à une extrémité à l'entrée 124 et à l'autre extrémité à la sortie 126.

La première branche 120 comprend une première partie 128 formée dans un premier matériau supraconducteur S1, une deuxième partie 130 formée dans un deuxième matériau supraconducteur S2 et une première jonction Josephson 132 interposée entre les deux parties 128 et 130. La première partie 128 de la première branche 120 s'étend entre l'entrée 124 et la première jonction Josephson 132 tandis que la deuxième partie 130 de la première branche 120 s'étend entre la première jonction Josephson 132 et la sortie 126.

Le premier matériau supraconducteur S1 de la première partie 128 de la première branche 120 est préférablement un supraconducteur à haute température critique (>26°K), du type de ceux qui sont connus sous l'abréviation YBaCuO. En variante, à la place de l'yttrium, est utilisé du néodyme, du dysprosium, de l'europium. De préférence, le supraconducteur est non métallique, et en particulier du type céramique à base d'oxyde de cuivre (ReBaCuO, où Re représente un élément chimique du type terre rare). Ces remarques s'appliquent aussi au deuxième matériau supraconducteur S2.

Selon une variante, les deux matériaux supraconducteurs S1 et S2 sont identiques, ce qui permet de faciliter la fabrication du composant 110.

La deuxième branche 122 comporte une première partie 134 formée dans le premier matériau supraconducteur S1, une deuxième partie 136 formée dans le deuxième matériau supraconducteur S2 et un dispositif 138 supraconducteur à interférences quantiques noté SQUID 138 dans toute la suite de la présente description.

Le SQUID 138 est interposé entre les deux parties 134 et 136 de la deuxième branche 122. Ainsi, la première partie 134 de la deuxième branche 122 s'étend entre l'entrée 124 et le SQUID 138 tandis que la deuxième partie 136 de la deuxième branche 122 s'étend entre le SQUID 138 et la sortie 126. Le SQUID 138 est agencé électriquement en parallèle de la première jonction Josephson 132.

Le SQUID 138 comprend une deuxième boucle 140 supraconductrice comportant une première ligne 142 et une deuxième ligne 144.

La première ligne 142 comprend une première partie 146 formée dans le premier matériau supraconducteur S1, une deuxième partie 148 formée dans le deuxième matériau supraconducteur S2 et une deuxième jonction Josephson 150 interposée entre les deux parties 146, 148 de la première ligne 142. La première partie 146 de la première ligne 142 s'étend entre la première partie 134 de la deuxième branche 122 et la deuxième jonction Josephson 150 tandis que la deuxième partie 148 de la première ligne 142 s'étend entre la deuxième jonction Josephson 150 et la deuxième partie 136 de la deuxième branche 122.

La deuxième ligne 144 comprend une première partie 152 réalisée dans le premier matériau supraconducteur S1, une deuxième partie 54 réalisée dans le deuxième matériau supraconducteur S2 et une troisième jonction Josephson 156 interposée entre les deux parties 152, 54 de la deuxième ligne 144 de sorte que la troisième jonction Josephson 156 est en parallèle avec la deuxième jonction Josephson 150. La première partie 152 de la deuxième ligne 144 s'étend entre la première partie 134 de la deuxième branche 122 et la troisième jonction Josephson 156 tandis que la deuxième partie 54 de la deuxième ligne 144 s'étend entre la troisième jonction Josephson 156 et la deuxième partie 136 de la deuxième branche 122.

Le SQUID 138 sert principalement de jonction Josephson unique dont le courant critique est ajustable par un moyen « électrique » (injection de flux dans la deuxième boucle 140 supraconductrice).

En variante, d'autres éléments non linéaires dont la caractéristique courant - tension c'est-à-dire la fonction qui permet d'exprimer le courant à partir de la tension est semblable à celle d'une jonction Josephson sont utilisés à la place des jonctions Josephson 132, 150 et 156. On appelle second rapport R2 le rapport entre le produit de l'inductance de la deuxième boucle 140 supraconductrice et du courant critique de la jonction Josephson équivalente aux deuxième jonction Josephson 150 et troisième jonction Josephson 156 et le quantum de flux $\Phi_0$. Le second rapport R2 est de préférence inférieur à 1. Cela se traduit mathématiquement par les relations suivantes :

$$R2 = \frac{L_2 I_{Ceq}}{\Phi_0} \leq 1$$

Où :

- $L_2$ est l'inductance de la deuxième boucle 140 supraconductrice, et
- $I_{Ceq}$ est le courant critique de la jonction Josephson équivalente aux deuxième jonction Josephson 150 et troisième jonction Josephson 156.

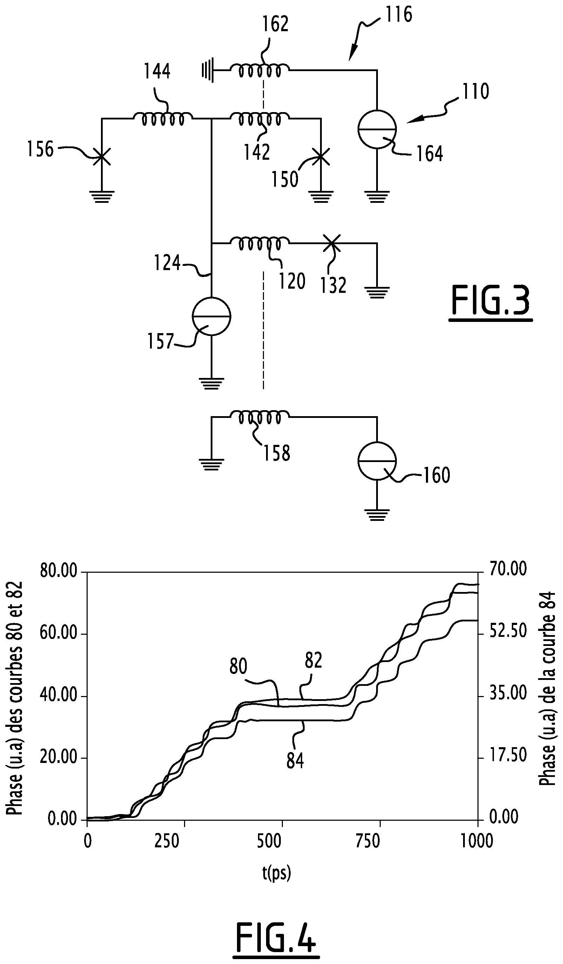

Selon l'exemple de la figure 2, par l'entrée 124 et la sortie 126, sont injectés des courants de polarisation des trois jonctions Josephson 132, 150 et 156 à l'aide d'un générateur de polarisation 157 visible sur la figure 3.

Dans le cas de la figure 2, le premier moyen de couplage 114 est sous la forme d'une première piste 158. La première piste 158 est une piste conductrice reliée à un premier générateur de courant 160 représenté sur la figure 3. La première piste 158 est en regard de la première branche 120, placée de façon à injecter efficacement un flux magnétique dans la première boucle 112.

La première piste 158 est propre à générer un premier courant I1 dans la première boucle 112 lorsque cette première piste 158 est alimentée en courant par le premier générateur de courant 160.

La première piste 158 sert notamment à concentrer le flux magnétique dans la boucle 112.

En variante, le premier moyen de couplage 114 est une bobine.

En outre, le premier générateur de courant 160 peut être remplacé par tout autre générateur électrique (de tension ou d'une grandeur électrique intermédiaire entre courant et tension).

Selon l'exemple de la figure 2, le deuxième moyen de couplage 116 est sous la forme d'une deuxième piste 162 couplée au SQUID 138. La deuxième piste 162 est une piste conductrice reliée à un deuxième générateur de courant 164 visible sur la figure 3. La deuxième piste 162 est en regard des lignes 142 et/ou 144 de façon à injecter efficacement un flux magnétique dans la seconde boucle 140.

La deuxième piste 162 est propre à générer un deuxième courant I2 dans la deuxième boucle 140 lorsque cette deuxième piste 162 est alimentée en courant par le deuxième générateur de courant 164.

Le deuxième générateur de courant 164 peut être remplacé par tout autre générateur électrique (de tension ou d'une grandeur électrique intermédiaire entre courant et tension).

Selon une variante, le composant 110 est pourvu d'un seul moyen de couplage 116 pour générer un courant uniquement dans la deuxième jonction Josephson 150 et la troisième jonction Josephson 156.

Par ailleurs, pour atteindre les meilleures performances, selon une autre variante, le premier courant critique $I_{C1}$ de la première jonction Josephson 132 est supérieur à la valeur absolue de la différence entre le troisième courant critique $I_{C3}$ de la troisième jonction Josephson 156 et le deuxième courant critique $I_{C2}$ de la deuxième jonction Josephson 150 et inférieur à la somme du troisième courant critique $I_{C3}$ et du deuxième courant critique $I_{C2}$. Ces inégalités s'écrivent mathématiquement comme une inégalité triangulaire :

$$|I_{C3} - I_{C2}| \leq I_{C1} \leq I_{C2} + I_{C3}$$

Le fonctionnement du composant 110 supraconducteur est maintenant décrit en référence à la figure 4.

Dans la simulation effectuée pour la figure 4, les valeurs de 100 μA (microampères), 160 μA et 80 μA ont respectivement été choisies pour le premier courant critique $I_{C1}$ de la première jonction Josephson 132, le deuxième courant critique $I_{C2}$ de la deuxième jonction Josephson 150 et le troisième courant critique $I_{C3}$ de la troisième jonction Josephson 156. Lorsque la deuxième piste 162 est alimentée par un courant augmentant de 0 à 400 μA, un flux magnétique proportionnel au temps est généré et appliqué au SQUID 138. Ainsi, en représentant l'évolution temporelle de la phase δ de la première Jonction Josephson 132 (courbe 80), de la deuxième jonction Josephson 150 (courbe 82) et de la troisième jonction Josephson 156 (courbe 84), il est observé le passage d'un état statique (les trois phases sont constantes) à un état dynamique (évolution monotone des phases pour chacune des jonctions Josephson).

Lorsque le flux magnétique créé par la deuxième piste 160 est proche d'un multiple du quantum de flux $\Phi_0$, le courant critique $I_{Ceq}$ de la jonction Josephson équivalente au SQUID 138 est maximum. Le courant critique $I_{C110}$ du composant 110 qui correspond au courant critique équivalent au SQUID 138 et à la première jonction Josephson est alors maximal. Le courant de polarisation injecté via l'entrée 124 et la sortie 126 du composant 110 est plus faible que le courant critique $I_{C110}$ du composant 110, de sorte que les trois jonctions Josephson 132, 150 et 156 sont toutes dans un état statique, c'est-à-dire un état dans lequel la différence de potentiel de part et d'autre des jonctions Josephson 132, 150 et 156 est nulle. Dans le cas de la simulation présentée figure 4, cet effet s'observe sur les plages de temps comprises entre 0 et 100 picosecondes (ps) et entre 400 ps et 650 ps.

Par contre, pour les plages de temps comprises entre 100 ps à 400 ps et entre 650 ps à 900 ps, le courant critique $I_{Ceq}$ de la jonction Josephson équivalente au SQUID 138 (de même que pour des résistances en parallèle, il peut être défini une jonction Josephson équivalente à deux jonctions Josephson en parallèle comme dans le cas du SQUID 138) est minimal. Le courant critique $I_{C110}$ du composant 110 est alors minimal. Le courant de polarisation injecté via l'entrée 124 et la sortie 126 du composant 110 est alors plus fort que le courant critique $I_{C110}$ du composant 110, de sorte que les trois jonctions Josephson 132, 150 et 156 sont toutes dans un état dynamique, c'est-à-dire un état dans lequel la phase de la jonction Josephson évolue de façon monotone avec le temps.

Ainsi, grâce au courant alimentant la deuxième piste 162, il est possible de régler le courant critique $I_{ceq}$ de la jonction Josephson équivalente au SQUID 138. De ce fait, le composant 110 supraconducteur se comporte comme un SQUID dont le courant critique peut être réduit jusqu'à zéro par un flux magnétique de contrôle, par exemple introduit par la deuxième piste 162.

Par rapport au SQUID à courant continu, le remplacement d'une des deux jonctions Josephson par le SQUID 138 dont la caractéristique courant - tension est ajustable permet d'obtenir un composant 110 ayant une amplitude de modulation maximale lorsque les courants critiques de la première jonction Josephson 132 et le courant critique du SQUID 138 sont égaux. Un tel composant 110 permet d'obtenir une réponse mieux contrôlée ayant notamment des applications pour des circuits amplificateurs. Plus généralement, cette propriété est utile pour toutes les applications où un très bon appariement des jonctions Josephson est souhaitable.

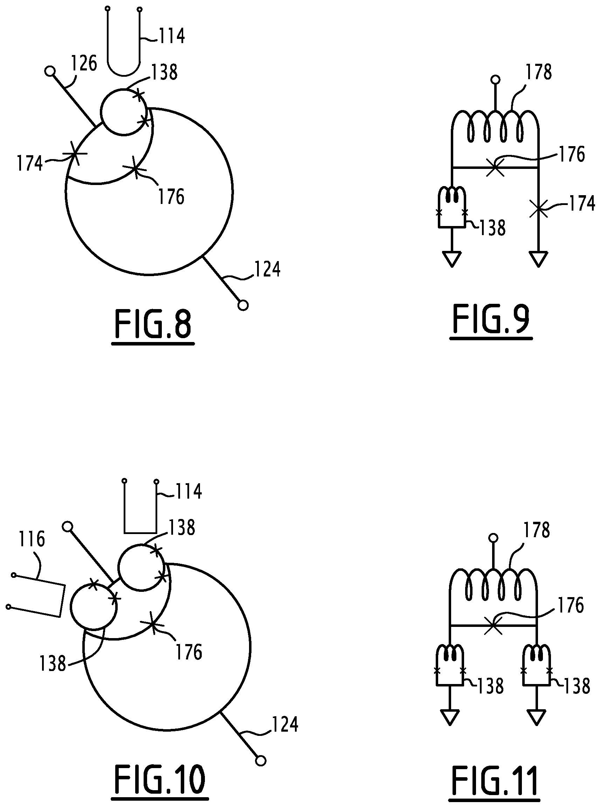

Selon un autre mode de réalisation tel que représenté à la figure 8, le composant 110 supraconducteur comprend les mêmes éléments que le composant 110 selon le premier mode de réalisation. Seules les différences sont mises en évidence. Une quatrième jonction Josephson 176 est ajoutée en parallèle avec la mise en série de la première partie 128 de la première branche 120 et la première partie 134 de la deuxième branche 122 ; la deuxième partie 130 de la première branche 120 et la deuxième partie 136 de la deuxième branche 122 étant de préférence raccourcies autant que possible.

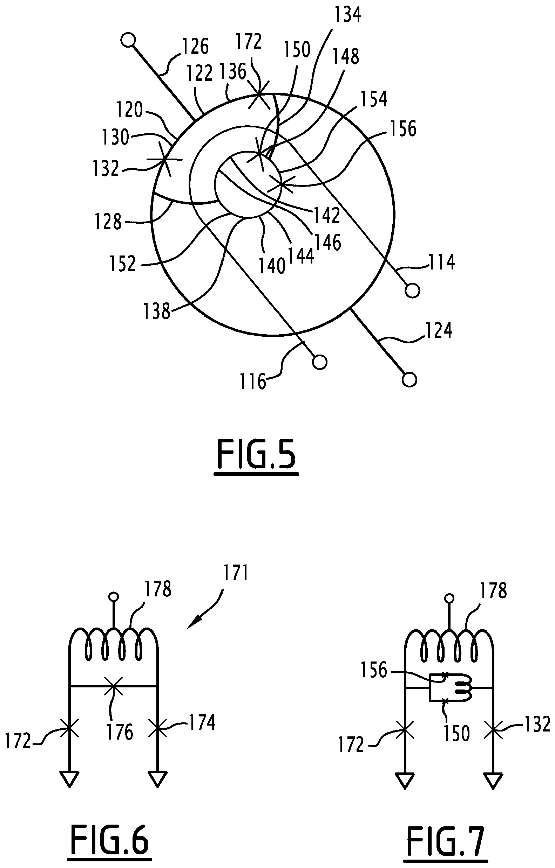

Ce montage est particulièrement avantageux puisqu'il combine les avantages de la présente invention avec ceux du circuit dit « BI-SQUID » tel que représenté figure 6 et décrit dans les références US-B-8 179 133 et dans la publication de Kornev et al. intitulée « DC SQUID array with nonlinear inductance » issue du Journal of Physics : Conférence Series 2134 (120110) 04120134. Le contenu de ces documents est inséré par référence dans ce brevet. Un circuit BI-SQUID est un circuit 171 tel que représenté à la figure 6. Il comporte trois jonctions Josephson 172, 174, 176 en série, les jonctions 172 et 174 constituant avec l'inductance de boucle 178 un composant SQUID ; la jonction Josephson 176 du milieu étant en parallèle avec l'inductance de boucle 178 constitue un deuxième SQUID (d'où l'appellation Bi-SQUID). Cela permet d'améliorer la linéarité du composant 110. Dans un mode de réalisation préféré, l'inductance de boucle 78 est principalement l'inductance formée par la première partie 28 de la première branche 20 et la première partie 34 de la deuxième branche 22 ; l'inductance formée par la deuxième partie 30 de la première branche 20 et la deuxième partie 36 de la deuxième branche 22 étant réduite par exemple en réduisant leurs longueurs.

Il peut être montré que la linéarité du circuit 171 de la figure 6 dépend fortement de la valeur du courant critique de la jonction Josephson 176 du milieu. Même si le composant décrit figure 8 offre l'avantage d'une possibilité de contrôle du courant critique, il est envisageable de le modifier en utilisant un ou plusieurs SQUID 138 pour régler le courant critique dans l'une quelconque des branches 120, 122 ou de la branche en parallèle obtenue avec la mise en série des conducteurs de la première partie 128 de la première branche 120 et la première partie 134 de la deuxième branche 122) comme illustré par les figures 5, 7, 8, 9, 10, 11, 12, 13.

La figure 5 montre cette modification pour que le contrôle du courant critique porte sur l'élément en parallèle avec l'inductance de boucle 178; cette figure 5 illustre également une possibilité de réalisation du circuit de commande du SQUID 138 sous forme d'une fourche positionnée à l'aplomb du SQUID 138, tout en ayant un faible coefficient de couplage avec les autres parties du circuit.

Lorsque le circuit électrique correspondant au mode de réalisation de la figure 5 est tracé comme le montre la figure 7, il apparaît qu'appliquer l'idée de la jonction Josephson à courant critique contrôlable revient à remplacer la jonction Josephson 176 du milieu par le SQUID 138. Avec la substitution effectuée, le courant critique est ajustable et ainsi, une bonne linéarité pour le composant est obtenue.

Bien entendu, ainsi que l'illustrent les figures 8 à 13, pour améliorer la linéarité du circuit BI-SQUID 171 d'autres configurations sont possibles puisque les courants critiques des différentes jonctions Josephson 172, 174, 176 sont simplement à ajuster les uns relativement aux autres.

Par exemple, comme le montrent les figures 8 et 9, il est également possible au lieu de remplacer la jonction Josephson 176 du milieu par le SQUID 138 de remplacer l'une des deux autres jonctions Josephson 172, 174 par le SQUID 138. Cette variante présente, en outre, l'avantage d'être simple à implémenter.

Selon un autre mode de réalisation présenté aux figures 10 et 11, il est aussi possible, au lieu de remplacer la jonction Josephson du milieu 176 par le SQUID 138, de remplacer les deux autres jonctions Josephson 172, 174 respectivement par un SQUID 138. Cette variante présente, en outre, l'avantage d'être simple à implémenter.

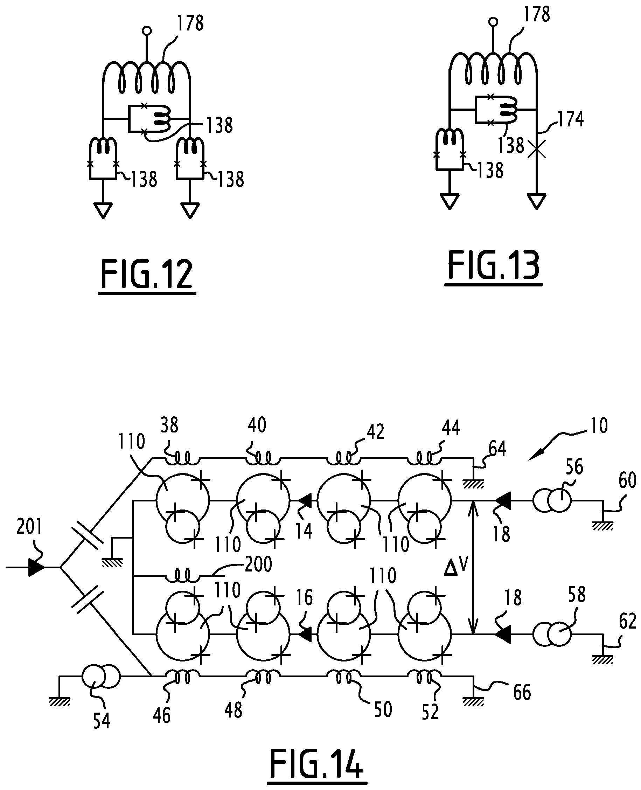

Selon un autre mode de réalisation illustré par la figure 12, les trois jonctions Josephson 172, 174, 176 sont remplacées chacune par un SQUID 138.

Selon encore un autre mode de réalisation qu'illustre la figure 13, la jonction Josephson du milieu 176 et une autre jonction Josephson 172, 174 sont chacune remplacées par un SQUID 138.

Ainsi qu'expliqué précédemment, l'utilisation du composant 110 supraconducteur proposé à la figure 2 permet de réduire le nombre de raies satellites générées par les non-linéarités du mélangeur 10.

C'est pourquoi il est proposé à la figure 14 une architecture de mélangeur 210 similaire à celle de la figure 1 dans laquelle des composants 110 conformes à la figure 2 remplacent les SQUID.

En outre, le mélangeur 210 comprend, pour chaque composant 10, un moyen de contrôle 200 du courant critique de ce composant 110.

Pour simplifier la figure 14, seul un moyen de contrôle 200 du courant critique dans le composant est représenté. Le moyen de contrôle 200 du courant critique dans le composant est un moyen de génération d'un flux magnétique. Plus précisément, le moyen de contrôle 200 du courant critique dans le composant est une inductance reliée à un générateur délivrant un courant noté $I_{contrôle}$, l'inductance étant placée à proximité du composant 110.

L'intérêt d'utiliser un composant 110 supraconducteur tel que proposé à la figure 2 pour le mélangeur 10 est expliqué en exposant le fonctionnement du mélangeur 10 de la figure 14.

Comme expliqué précédemment, le composant 110 supraconducteur se comporte comme une jonction Josephson dont le courant critique est contrôlable par un flux magnétique de contrôle. Appliqué à la première paire de composants 10 montés en différentiel, cela permet ainsi d'équilibrer les produits $R_n*I_k$ (l'indice $k$ désigne le numéro du composant 110 considéré) de la première paire de composants 110 du mélangeur 210 par simple modification du flux magnétique de contrôle appliqué. Cet équilibrage permet d'éliminer une raie parasite.

Ce principe appliqué à une première raie parasite peut s'appliquer ensuite à la deuxième paire de composants 110 pour une deuxième raie parasite.

De proche en proche, il est ainsi possible d'obtenir une réponse du mélangeur 10 proche d'un fonctionnement idéal.

Un tel mélangeur 10 permet donc d'éviter de fausses détections.

De manière générale, le mélangeur 10 présentant au moins un doublet d'éléments supraconducteurs à interférence quantique tels que décrits précédemment permet d'éviter l'apparition de raies parasites. Selon les variantes, ces éléments supraconducteurs à interférence quantique sont deux SQUID, une combinaison d'un SQUID et d'un composant 110 ou deux composants 110. Le ou chaque composant 110 est, selon les modes de réalisation, un composant tel qu'illustré aux figures 2, 3, 5 à 13.

**Revendications**

1. Mélangeur (10) comprenant :

   • une entrée (12, 201) d'injection d'un premier signal,
   • deux entrées (14, 16) pour un deuxième signal, la différence de potentiel entre les deux entrées (14, 16) correspondant à la tension du deuxième signal, le deuxième signal étant appliqué sur chacune des deux entrées (14, 16),
   • deux sorties (18, 20), la différence de potentiel entre les deux sorties (18, 20) correspondant à une multiplication du premier signal avec le deuxième signal,
   • deux générateurs de polarisation (56, 58),
   • deux premiers éléments supraconducteurs à interférence quantique (22, 24, 26, 28, 30, 32, 34, 36, 110) montés en différentiel formant un premier doublet, et reliés chacun à une des sorties (18, 20) du mélangeur (10), à une des deux entrées (14, 16) pour le deuxième signal et à un des générateurs de polarisation (56, 58), chaque générateur de polarisation (56, 58) étant propre à polariser chaque élément supraconducteur à interférence quantique (22, 24, 26, 28, 30, 32, 34, 36, 110) avec un courant continu et

• un moyen de contrôle (200) d'une différence de flux magnétique appliqué aux deux éléments supraconducteurs à interférence quantique (22, 24, 26, 28, 30, 32, 34, 36, 110) du premier doublet, le moyen de contrôle (200) comprenant deux inductances (38, 40, 42, 44, 46, 48, 50, 52) reliées à un générateur de courant (54), chaque inductance étant en regard d'un élément supraconducteur à interférence quantique (22, 24, 26, 28, 30, 32, 34, 36, 110) respectif du premier doublet et les inductances étant alimentées de manière à ce qu'une des inductances génère un flux de polarité opposé au flux de polarité généré par l'autre inductance, le moyen de contrôle étant relié à l'entrée (12, 201) d'injection du premier signal,

dans lequel un au moins des éléments supraconducteurs à interférence quantique des doublets (22, 24, 26, 28, 30, 32, 34, 36, 110) est un composant (110) supraconducteur, comprenant une première boucle (112) supraconductrice, la première boucle (112) supraconductrice comportant une première branche (120) comprenant une première jonction Josephson (132) et une deuxième branche (122) comprenant un premier dispositif supraconducteur à interférence quantique (138) à courant continu,

dans lequel la deuxième branche (122) comporte une première ligne (142) et une deuxième ligne (144), le premier dispositif supraconducteur à interférence quantique (138) à courant continu du ou de chaque composant (110) comportant une deuxième jonction Josephson (150) dans la première ligne (142) et une troisième jonction Josephson (156) dans la deuxième ligne (144) et agencée en parallèle de la deuxième jonction Josephson (150), un courant critique ($I_{C1}$, $I_{C2}$, $I_{C3}$) étant défini pour chaque jonction Josephson (132, 150, 156), le courant critique ($I_{C1}$) de la première jonction Josephson (132) est supérieur à la valeur absolue de la différence entre le courant critique ($I_{C3}$) de la troisième jonction Josephson (156) et le courant critique ($I_{C2}$) de la deuxième jonction Josephson (150) et inférieur à la somme du courant critique ($I_{C2}$) de la deuxième jonction Josephson (150) et du courant critique ($I_{C3}$) de la troisième jonction Josephson (156), et

dans lequel le ou chaque composant (110) comprend des moyens de couplage de flux magnétique (114, 116, 158, 160 et 162) sous forme d'une première piste (158) au regard de la première branche (120) et d'une deuxième piste (162) au regard d'une de la première ligne (142) et d'une deuxième ligne (144), les moyens de couplage de flux magnétique (114, 116, 158, 160, et 162) étant agencés de façon à injecter efficacement un flux magnétique dans la première boucle (112) supraconductrice et le premier dispositif supraconducteur à interférence quantique (138) à courant continu.

2. Mélangeur selon la revendication 1, dans lequel sont interposés en série entre les deux premiers éléments supraconducteurs à interférence quantique (22, 24, 26, 28, 30, 32, 34, 36, 110) et les deux sorties (18, 20) :

   • au moins deux deuxièmes doublets comprenant deux éléments supraconducteurs à interférence quantique (22, 24, 26, 28, 30, 32, 34, 36, 110) montés en différentiel et reliés chacun à une des sorties (18, 20) du mélangeur (10) et à une des deux entrées (14, 16) pour le deuxième signal, et
   • un moyen de contrôle (200) d'une différence de flux magnétique appliqué aux deux éléments supraconducteurs à interférence quantique (22, 24, 26, 28, 30, 32, 34, 36, 110) de chaque deuxième doublet, les moyens de contrôle étant des inductances reliées à un générateur de courant, chaque inductance étant en regard respectivement d'un élément supraconducteur à interférence quantique (22, 24, 26, 28, 30, 32, 34, 36, 110) d'un des deuxièmes doublets, les inductances formant des lignes avec les inductances en regard des deux éléments supraconducteurs à interférence quantique (22, 24, 26, 28, 30, 32, 34, 36, 110) du premier doublet.

3. Mélangeur selon la revendication 1 ou 2, dans lequel au moins un composant (110) comprend en outre une quatrième jonction Josephson (176) en parallèle avec une partie (128) de la première branche (120) et une partie (134) de la deuxième branche (122), les deux parties (128, 134) formant une inductance de boucle (178) en parallèle de la quatrième jonction Josephson (176).

4. Mélangeur selon la revendication 1 ou 2, dans lequel la deuxième branche d'au moins un composant (110) comprend le premier dispositif supraconducteur à interférence quantique (138) à courant continu, monté en parallèle avec une inductance de boucle (178) formée par une partie (128) de la première branche (120) et une partie (134) de la deuxième branche (122), l'ensemble étant monté en série avec une quatrième jonction Josephson (172) dont le courant critique est égal au courant critique de la première jonction Josephson (132) à 1% près.

5. Mélangeur selon la revendication 3 ou 4, dans lequel ledit au moins un composant (110) comprend en outre une cinquième jonction Josephson agencée pour que la première jonction Josephson (132) et la cinquième jonction Josephson forment un deuxième dispositif supraconducteur à interférence quantique à courant continu distinct du premier dispositif supraconducteur à interférence quantique (138) à courant continu.

**EP 3 143 692 B1**

**6.** Mélangeur selon la revendication 4, dans lequel ledit au moins un composant (110) comprend en outre :

- une cinquième jonction Josephson agencée pour que la première jonction (32) Josephson et la cinquième jonction Josephson forment un deuxième dispositif supraconducteur à interférence quantique à courant continu distinct du premier dispositif supraconducteur à interférence quantique (138) à courant continu, et
- une sixième jonction Josephson agencée pour que la quatrième jonction Josephson et la sixième jonction Josephson forment un troisième dispositif supraconducteur à interférence quantique à courant continu distinct du premier dispositif supraconducteur à interférence quantique (138) à courant continu et du deuxième dispositif supraconducteur à interférence quantique.

**Patentansprüche**

**1.** Mischeinrichtung (10), aufweisend:

• einen Eingang (12, 201) zum Einbringen eines ersten Signals,
• zwei Eingänge (14, 16) für ein zweites Signal, wobei die Potentialdifferenz zwischen den zwei Eingängen (14, 16) der Spannung des zweiten Signals entspricht, wobei das zweite Signal an jeden der zwei Eingänge (14, 16) angelegt ist,
• zwei Ausgänge (18, 20), wobei die Potentialdifferenz zwischen den zwei Ausgängen (18, 20) einer Multiplikation des ersten Signals mit dem zweiten Signal entspricht,
• zwei Polarisationserzeuger (56, 58),
• zwei erste supraleitende Quanteninterferenz-Elemente (22, 24, 26, 28, 30, 32, 34, 36, 110), welche differentiell angebracht sind, wobei sie ein erstes Dublett bilden, und welche jeweils mit einem der Ausgänge (18, 20) der Mischeinrichtung (10), mit einem der Eingänge (14, 16) für das zweite Signal und mit einem der Polarisationserzeuger (56, 58) verbunden sind, wobei jeder Polarisationserzeuger (56, 58) dazu geeignet ist, jedes supraleitende Quanteninterferenz-Element (22, 24, 26, 28, 30, 32, 34, 36, 110) mit einem Gleichstrom zu polarisieren, und
• ein Mittel zur Steuerung (200) einer Differenz des magnetischen Flusses, der an zwei supraleitende Quanteninterferenz-Elemente (22, 24, 26, 28, 30, 32, 34, 36, 110) des ersten Dubletts angelegt wird, wobei die Mittel zur Steuerung (200) zwei Induktivitäten (38, 40, 42, 44, 46, 48, 50, 52), welche mit einem Stromerzeuger (54) verbunden sind, aufweisen, wobei jede Induktivität einem jeweiligen supraleitenden Quanteninterferenz-Element (22, 24, 26, 28, 30, 32, 34, 36, 110) des ersten Dubletts gegenüberliegt und wobei die Induktivitäten derart gespeist werden, dass eine der Induktivitäten einen Polaritätsfluss, der zu dem durch die andere Induktivität erzeugten Polaritätsfluss entgegengesetzt ist, erzeugt, wobei das Mittel zur Steuerung (200) mit dem Eingang (12, 201) zum Einbringen des ersten Signals verbunden ist,

wobei mindestens eines der supraleitenden Quanteninterferenz-Elemente von Dubletten (22, 24, 26, 28, 30, 32, 34, 36, 110) eine Supraleiter-Komponente (110) ist, welche eine erste supraleitende Schleife (112) aufweist, wobei die erste supraleitende Schleife (112) einen ersten Zweig (120), welcher einen ersten Josephson-Kontakt (132) aufweist, und einen zweiten Zweig (122), welcher eine erste supraleitende Gleichstrom-Quanteninterferenz-Vorrichtung (138) aufweist, aufweist, wobei der zweite Zweig (122) eine erste Leitung (142) und eine zweite Leitung (144) aufweist, wobei die erste supraleitende Gleichstrom-Quanteninterferenz-Vorrichtung (138) der oder jeder Komponente (110) einen zweiten Josephson-Kontakt (150) in der ersten Leitung (142) und einen dritten Josephson-Kontakt (156), welcher sich in der zweiten Leitung (144) befindet und parallel zum zweiten Josephson-Kontakt (150) angeordnet ist, aufweist, wobei ein kritischer Strom ($I_{C1}$, $I_{C2}$, $I_{C3}$) für jeden Josephson-Kontakt (132, 150, 156) definiert ist, wobei der kritische Strom ($I_{C1}$) des ersten Josephson-Kontakts (132) größer als der Absolutwert der Differenz zwischen dem kritischen Strom ($I_{C3}$) des dritten Josephson-Kontakts (156) und dem kritischen Strom ($I_{C2}$) des zweiten Josephson-Kontakts (150) ist und kleiner als die Summe des kritischen Stroms ($I_{C2}$) des zweiten Josephson-Kontakts (150) und des kritischen Stroms ($I_{C3}$) des dritten Josephson-Kontakts (156) ist, und wobei die oder jede Komponente (110) Mittel zur Magnetflusskopplung (114, 116, 158, 160 und 162) in der Form einer ersten Bahn (158) in Bezug auf den ersten Zweig (120) und einer zweiten Bahn (162) in Bezug auf eine von der ersten Leitung (142) und der zweiten Leitung (144) aufweist, wobei die Mittel zur Magnetflusskopplung (114, 116, 158, 160 und 162) so angeordnet sind, dass effektiv ein Magnetfluss in die erste supraleitende Schleife (112) und die erste supraleitende Gleichstrom-Quanteninterferenz-Vorrichtung (138) eingebracht wird.

**2.** Mischeinrichtung gemäß dem Anspruch 1, in welcher zwischen den zwei supraleitenden Quanteninterferenz-Elementen (22, 24, 26, 28, 30, 32, 34, 36, 110) ein und den zwei Ausgängen (18, 20) in Reihe angeordnet sind:

• mindestens zwei zweite Dublette, aufweisend zwei supraleitenden Quanteninterferenz-Elementen (22, 24, 26, 28, 30, 32, 34, 36, 110), welche differentiell angebracht sind und welche jeweils mit einem der Ausgänge (18, 20) der Mischeinrichtung (10) und mit einem der Eingänge (14, 16) für das zweite Signal verbunden sind, und
• ein Mittel zur Steuerung (200) einer Differenz des magnetischen Flusses, der an zwei supraleitende Quanteninterferenz-Elemente (22, 24, 26, 28, 30, 32, 34, 36, 110) jedes zweiten Dubletts angelegt wird, wobei die Mittel zur Steuerung Induktivitäten sind, welche mit einem Stromerzeuger (54) verbunden sind, wobei jede Induktivität jeweils einem supraleitenden Quanteninterferenz-Element (22, 24, 26, 28, 30, 32, 34, 36, 110) von einem der zweiten Dubletts gegenüberliegt, wobei die Induktivitäten Leitungen mit den Induktivitäten, welche den zwei supraleitenden Quanteninterferenz-Element (22, 24, 26, 28, 30, 32, 34, 36, 110) des ersten Dubletts gegenüberliegen, bilden.

3. Mischeinrichtung gemäß dem Anspruch 1 oder 2, wobei mindestens eine Komponente (110) ferner einen vierten Josephson-Kontakt (176) parallel zu einem Abschnitt (128) des ersten Zweigs (120) und einem Abschnitt (134) des zweiten Zweigs (122) aufweist, wobei die zwei Abschnitte (128, 134) eine Schleifeninduktivität (178) parallel zum vierten Josephson-Kontakt (176) bilden.

4. Mischeinrichtung gemäß dem Anspruch 1 oder 2, wobei der zweite Zweig der mindestens einen Komponente (110) die erste supraleitende Gleichstrom-Quanteninterferenz-Vorrichtung (138) aufweist, welche parallel zu einer Schleifeninduktivität (178), die durch einen Abschnitt (128) des ersten Zweigs (120) und einen Abschnitt (134) des zweiten Zweigs (122) gebildet wird, angebracht ist, wobei die Anordnung in Serie mit einem vierten Josephson-Kontakt (172) angebracht ist, dessen kritischer Strom gleich dem kritischen Strom des ersten Josephson-Kontakts (132) bis auf 1% genau ist.

5. Mischeinrichtung gemäß dem Anspruch 3 oder 4, wobei die mindestens eine Komponente (110) ferner einen fünften Josephson-Kontakt aufweist, welcher so angeordnet ist, dass der erste Josephson-Kontakt (132) und der fünfte Josephson-Kontakt eine zweite supraleitende Gleichstrom-Quanteninterferenz-Vorrichtung bilden, welche verschieden von der ersten supraleitenden Gleichstrom-Quanteninterferenz-Vorrichtung (138) ist.

6. Mischeinrichtung gemäß dem Anspruch 4, wobei die mindestens eine Komponente (110) ferner aufweist:

- einen fünften Josephson-Kontakt, welcher so angeordnet ist, dass der erste Josephson-Kontakt (32) und der fünfte Josephson-Kontakt eine zweite supraleitende Gleichstrom-Quanteninterferenz-Vorrichtung bilden, welche verschieden von der ersten supraleitenden Gleichstrom-Quanteninterferenz-Vorrichtung (138) ist, und
- einen sechsten Josephson-Kontakt, welcher so angeordnet ist, dass der vierte Josephson-Kontakt und der sechste Josephson-Kontakt eine dritte supraleitende Gleichstrom-Quanteninterferenz-Vorrichtung bilden, welche verschieden von der ersten supraleitenden Gleichstrom-Quanteninterferenz-Vorrichtung (138) und von der zweiten supraleitenden Gleichstrom-Quanteninterferenz-Vorrichtung ist.

**Claims**

1. Mixer (10) comprising:

• an input (12, 201) for injection of a first signal,
• two inputs (14, 16) for a second signal, the potential difference between the two inputs (14, 16) corresponding to the voltage of the second signal, the second signal being applied to each of the two inputs (14, 16),
• two outputs (18, 20), the potential difference between the two outputs (18, 20) corresponding to a multiplication of the first signal by the second signal,
• two polarisation generators (56, 58),
• two first superconducting quantum interference elements (22, 24, 26, 28, 30, 32, 34, 36, 110) which are mounted differentially to form a first doublet and are each connected to one of the outputs (18, 20) of the mixer (10), to one of the two inputs (14, 16) for the second signal and to one of the polarisation generators (56, 58), each polarisation generator (56, 58) being capable of polarising each superconducting quantum interference element (22, 24, 26, 28, 30, 32, 34, 36, 110) with a direct current, and
• a control means (200) for controlling a difference in magnetic flux applied to the two superconducting quantum interference elements (22, 24, 26, 28, 30, 32, 34, 36, 110) of the first doublet, the control means (200) comprising two inductive resistors (38, 40, 42, 44, 46, 48, 50, 52) connected to a current generator (54), each inductive resistor being opposite a respective superconducting quantum interference element (22, 24, 26, 28, 30, 32, 34, 36, 110) of the first doublet and the inductive resistors being supplied in such a manner that one of the inductive resistors generates a flux of opposite polarity to the flux of polarity generated by the other inductive resistor, the control means being connected to the input (12, 201) for injection of the first signal,

wherein at least one of the superconducting quantum interference elements of the doublets (22, 24, 26, 28, 30, 32, 34, 36, 110) is a superconducting component (110) comprising a first superconducting loop (112), the first superconducting loop (112) comprising a first branch (120) comprising a first Josephson junction (132) and a second branch (122) comprising a first direct current superconducting quantum interference device (138),
wherein the second branch (122) comprises a first line (142) and a second line (144), the first direct current superconducting quantum interference device (138) of the or of each component (110) comprising a second Josephson junction (150) in the first line (142) and a third Josephson junction (156) in the second line (144) and arranged in parallel with the second Josephson junction (150), a critical current ($I_{C1}$, $I_{C2}$, $I_{C3}$) being defined for each Josephson junction (132, 150, 156), the critical current ($I_{C1}$) of the first Josephson junction (132) is greater than the absolute value of the difference between the critical current ($I_{C3}$) of the third Josephson junction (156) and the critical current ($I_{C2}$) of the second Josephson junction (150) and less than the sum of the critical current ($I_{C2}$) of the second Josephson junction (150) and the critical current ($I_{C3}$) of the third Josephson junction (156), and
wherein the or each component (110) comprises magnetic flux coupling means (114, 116, 158, 160 and 162) in the form of a first track (158) opposite one of the first line (142) and a second line (144), the magnetic flux coupling means (114, 116, 158, 160 and 162) being arranged so as to effectively inject a magnetic flux into the first superconducting loop (112) and the first direct current superconducting quantum interference device (138).

2. Mixer according to claim 1, wherein there are interposed in series between the two first superconducting quantum interference elements (22, 24, 26, 28, 30, 32, 34, 36, 110) and the two outputs (18, 20):

   • at least two second doublets comprising two superconducting quantum interference elements (22, 24, 26, 28, 30, 32, 34, 36, 100) which are mounted differentially and each connected to one of the outputs (18, 20) of the mixer (10) and to one of the two inputs (14, 16) for the second signal, and
   • a control means (200) for controlling a difference in magnetic flux applied to the two superconducting quantum interference elements (22, 24, 26, 28, 30, 32, 34, 36, 110) of each second doublet, the control means being inductive resistors connected to a current generator, each inductive resistor being opposite a respective superconducting quantum interference element (22, 24, 26, 28, 30, 32, 34, 36, 110) of one of the second doublets, the inductive resistors forming lines with the inductive resistors opposite the two superconducting quantum interference elements (22, 24, 26, 28, 30, 32, 34, 36, 110) of the first doublet.

3. Mixer according to claim 1 or 2, wherein at least one component (110) further comprises a fourth Josephson junction (176) in parallel with a part (128) of the first branch (120) and a part (134) of the second branch (122), the two parts (128, 134) forming an inductive loop resistor (178) in parallel with the fourth Josephson junction (176).

4. Mixer according to claim 1 or 2, wherein the second branch of at least one component (110) comprises the first direct current superconducting quantum interference device (138) mounted in parallel with an inductive loop resistor (178) formed by a part (128) of the first branch (120) and a part (134) of the second branch (122), the whole being mounted in series with a fourth Josephson junction (172), the critical current of which is equal to the critical current of the first Josephson junction (132) to within 1%.

5. Mixer according to claim 3 or 4, wherein said at least one component (110) further comprises a fifth Josephson junction arranged so that the first Josephson junction (132) and the fifth Josephson junction form a second direct current superconducting quantum interference device separate from the first direct current superconducting quantum interference device (138).

6. Mixer according to claim 4, wherein said at least one component (110) further comprises:

   - a fifth Josephson junction arranged so that the first Josephson junction (32) and the fifth Josephson junction form a second direct current superconducting quantum interference device separate from the first direct current superconducting quantum interference device (138), and
   - a sixth Josephson junction arranged so that the fourth Josephson junction and the sixth Josephson junction form a third direct current superconducting quantum interference device separate from the first direct current superconducting quantum interference device (138) and from the second direct current superconducting quantum interference device.

## FIG.1

## FIG.2

FIG.3

FIG.4

FIG.5

FIG.6

FIG.7

FIG.8

FIG.9

FIG.10

FIG.11

FIG.12

FIG.13

FIG.14

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4051393 A
- US 5646526 A
- EP 05024473 A

- US 8179133 B1
- US 8179133 B

**Littérature non-brevet citée dans la description**

- **KORNEV et al.** DC SQUID array with nonlinear inductance. *Journal of Physics : Conférence Series,* vol. 2134 (120110), 04120134